# EUROPEAN PATENT APPLICATION

(11) **EP 4 249 876 A1**
(43) Date of publication of application: **27.09.2023**
(21) Application number: 23160841.5
(22) Date of filing: 08.03.2023
(51) Int. Cl.: G01L 3/04, G01L 1/16

(54) **SENSING ELEMENT AND RELATED METHODS**

(30) Priority: 23.03.2022 US 202217702596
(71) Applicant: General Electric Company, Schenectady, NY 12345 (US)
(72) Inventor: MACDONALD, Robert James, Niskayuna, 12309 (US); LIN, Yizhen, Niskayuna, 12309 (US); YOST, Nicholas, Niskayuna, 12309 (US); ESLER, David Richard, Niskayuna, 12309 (US)
(74) Representative: Openshaw & Co.

(57) **Abstract**

A sensing element having improved temperature and pressure characteristics including at least one acoustic sensing device (101) formed mainly from a silicon substrate (102) and having a microelectromechanical system (104) without the use of quartz or polymer, wherein the at least one acoustic sensing device (101) detects a torque associated with a metal object (120) subject to said torque, and a high temperature bonding surface for directly connecting the sensing element to the metal object (120) via a high temperature connecting processes comprising at least one of soldering, metalizing and/or brazing, without the need for a polymer adhesive. Related sensors (100) using such sensing elements and methods are also disclosed herein.

## Description

### Technical Field

These teachings relate generally to sensing elements and more particularly to sensors for rotating machinery and related methods.

### Background

Sensors are used in numerous applications, including those that involve rotating machinery, such as for example, engine applications for things like rockets, aircraft, automobiles and wind turbines. Often it is important to monitor conditions, such as pressure and temperature, with such equipment to ensure proper performance and/or prevent damage to same. For example, in many rotating shaft applications, it is desired to monitor torque relating to the rotating shaft via a torque sensor to ensure it is operating within desired parameters.

In the past, acoustic wave sensors, such as surface acoustic wave (SAW) sensing components and bulk acoustic wave (BAW) sensing components have been used to measure torque. Changes in the acoustic wave characteristics can be monitored by measuring the frequency, amplitude or phase characteristics of the sensor and can then be correlated to the corresponding item being monitored to determine performance characteristics of same.

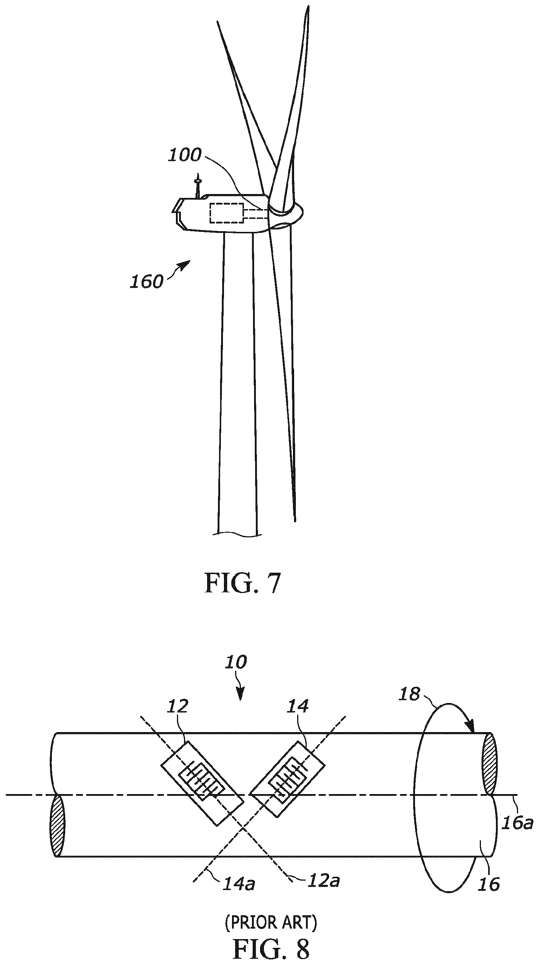

In FIG. 8, a prior art configuration for a SAW sensor is illustrated and referred to generally by reference numeral 10. In this example, the sensor 10 includes a first transducer 12 and a second transducer 14 positioned at ninety degrees (90°) to one another as illustrated by the respective longitudinal axes 12a, 14a, and at forty-five degrees (45°) to the longitudinal axis 16a of shaft 16. With this configuration, when the shaft 16 rotates the performance of the transducers 12, 14 will change. For example, when the shaft 16 is rotated clockwise in the direction shown by arrow 18, compressive stress will be induced in SAW transducer 14 and tensile stress will be induced in SAW transducer 12. Temperature changes would apply equally to the transducers 12, 14, so that does not need to be taken into account for measurement purposes, but temperature as a whole can certainly limit the application for such sensors (e.g., the sensors have to be able to withstand the temperature extremes to which they will be exposed).

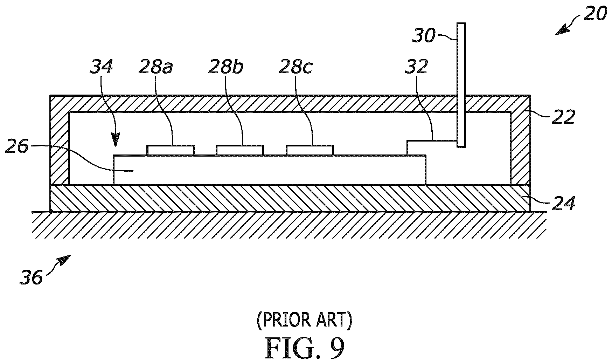

Conventional strain or torque sensors have utilized the physics described above for many years. To try and improve on the durability and usefulness of such sensors, conventional strain and torque sensors have been provided in all quartz packaging (AQP) to help seal and protect them from the surrounding environmental conditions. For example, a conventional AQP SAW-based torque sensor is illustrated in FIG. 9 and referenced generally by reference numeral 20. In this implementation, a quartz cover 22 is placed over a substrate or base 24. A diaphragm 26 is seated on the substrate or base 24, and acoustic sensing elements 28a, 28b, 28c are positioned on the diaphragm 26. Further an antenna 30 is connected to the circuit of the diaphragm 26 via conductor 32, to allow the sensor 20 to communicate with a remote system such as a controller or control device (not shown). An inert gas would be trapped in the gap 34 formed between the cover 22 and base 24. This sensor would then be mounted via an adhesive such as a soft polymer to anything that torque is desired to be monitored for (e.g., rotating shafts, flexing surfaces, etc.) which is represented as surface 36. Unfortunately, such configurations are still not usable in all desired applications and can be improved upon.

Thus, a need exists for an improved sensing element and sensor using same, and related methods.

### Brief Description of the Drawings

Various needs are at least partially met through provision of the SENSING ELEMENT AND RELATED METHODS described in the following detailed description, particularly when studied in conjunction with the drawings. A full and enabling disclosure of the aspects of the present description, including the best mode thereof, directed to one of ordinary skill in the art, is set forth in the specification, which refers to the appended figures, in which:
FIG. 1 comprises a schematic view of an exemplary sensor with sensing elements as configured in accordance with various embodiments of these teachings and as used on a rotating shaft for torque sensing purposes;
FIG. 2 comprises a side view or cross-sectional view of a sensing element for the sensor shown in FIG. 1 as configured in accordance with various embodiments of these teachings;
FIG. 3 is a model of a silicon resonator sensing element as used in the sensor of FIG. 1 and as configured in accordance with various embodiments of these teachings;
FIG. 4 is a chart illustrating change in frequency of the silicon resonator sensing element versus strain (or microstrain) of the silicon resonator of FIG. 3 and as configured in accordance with various embodiments of these teachings;
FIG. 5 is a cross-sectional schematic view of a jet engine utilizing a torque sensor in accordance with the sensing elements and sensor of FIGS. 1 and 2, and as configured in accordance with various embodiments of these teachings;
FIG. 6 is a cross-section schematic view of a gas turbine engine utilizing a torque sensor in accordance with the sensing elements and sensor of FIGS. 1 and 2, and as configured in accordance with various embodiments of these teachings;
FIG. 7 is a cross-sectional schematic view of an air turbine utilizing a torque sensor in accordance with the sensing element and sensor of FIGS. 1 and 2, and as configured in accordance with various embodiments of these teachings;
FIG. 8 is a cross-sectional schematic view of a conventional SAW resonator transducer systems for dynamic torque measurement;
FIG. 9 is a cross-sectional schematic view of a conventional AQP torque sensor.

Elements in the figures are illustrated for simplicity and clarity and have not necessarily been drawn to scale. For example, the dimensions and/or relative positioning of some of the elements in the figures may be exaggerated relative to other elements to help to improve understanding of various embodiments of the present teachings. Also, common but well-understood elements that are useful or necessary in a commercially feasible embodiment are often not depicted in order to facilitate a less obstructed view of these various embodiments of the present teachings. Certain actions and/or steps may be described or depicted in a particular order of occurrence while those skilled in the art will understand that such specificity with respect to sequence is not actually required.

### Detailed Description

As mentioned above, it is common to use sensors to monitor conditions of equipment before, during and after use. With respect to rotating machinery, it is common to use torque sensors to ensure that the machinery is operating within desired parameters. These sensors typical use sensing elements (or sense elements), such as resonators, to accomplish the desired sensing. Unfortunately, conventional AQP torque sensors and their sensing elements must be packaged using soft polymers and rigid/brittle quartz. Given the use of polymers, the sensing elements must also be bonded via polymers, such as polymer adhesives. Mechanical properties of polymers and polymer adhesives are limited compared to metal attachment methods. For example, polymers cannot be subjected to the same high temperature and/or high-pressure processes used during fabrication or assembly that metal attachment processes regularly involve. In addition, quartz is brittle, can crack, and thus is not forgiving, so all of these faults create problems that limit the types of processes that such items can be subjected to and makes the sensor subject to weaknesses that would not otherwise affect the application or equipment used in a particular application but for these drawbacks with the use of quartz and polymers. For example, these drawbacks make the AQP torque sensor susceptible to vibration and creep over time, and can make the sensor sensitive to temperature. Further, more reliable manufacturing and assembly processes cannot be used due to the sensitivity AQP torque sensors have to temperature. All of these things impact the accuracy and life of the sensor and can cause damage to the sensor and/or the item the sensor is monitoring if the sensor is not properly performing.

Generally speaking, the various aspects of the present disclosure can be employed with a sensing element having improved temperature and pressure characteristics including at least one acoustic sensing device formed mainly from a silicon substrate and having a microelectromechanical system without the use of quartz or polymer, wherein the at least one acoustic sensing device detects a torque associated with a metal object subject to said torque, and a high temperature bonding surface for directly connecting the sensing element to the metal object via a high temperature connecting processes comprising at least one of soldering, metalizing and/or brazing, without the need for a polymer adhesive. Related methods are also disclosed herein.

The terms and expressions used herein have the ordinary technical meaning as is accorded to such terms and expressions by persons skilled in the technical field as set forth above except where different specific meanings have otherwise been set forth herein. The word "or" when used herein shall be interpreted as having a disjunctive construction rather than a conjunctive construction unless otherwise specifically indicated. The terms "coupled," "fixed," "attached to," and the like refer to both direct coupling, fixing, or attaching, as well as indirect coupling, fixing, or attaching through one or more intermediate components or features, unless otherwise specified herein.

The singular forms "a", "an", and "the" include plural references unless the context clearly dictates otherwise.

Approximating language, as used herein throughout the specification and claims, is applied to modify any quantitative representation that could permissibly vary without resulting in a change in the basic function to which it is related. Accordingly, a value modified by a term or terms such as "about", "approximately", and "substantially", are not to be limited to the precise value specified. In at least some instances, the approximating language may correspond to the precision of an instrument for measuring the value, or the precision of the methods or machines for constructing or manufacturing the components and/or systems. For example, the approximating language may refer to being within a 10 percent margin.

The foregoing and other benefits may become clearer upon making a thorough review and study of the following detailed description. As mentioned above, prior sensors, sensing elements and processes are illustrated in FIGs. 8 and 9, and these embodiments, along with the patents explaining same (i.e., EP0518900B1 issued July 30, 1997 to Lonsdale (FIG. 8) and US7302864B2 issued December 4, 2007 to Liu (FIG. 9)) are incorporated herein by reference in their entirety. However, these all have drawbacks regarding strength of materials used and processes that can be used for manufacture and/or assembly. For example, these conventional sensors use polymers and quarts, which each have limitations as to the temperature the sensors or sensing elements that make up the sensors can be subjected to (or withstand) and pressures the sensors or sensing elements can withstand. In view of this, these sensors and sensing elements can only be assembled or connected to surfaces with polymers which cannot withstand the heat and pressure that other materials can withstand such as other high temperature and/or high-pressure metal attachment processes (e.g., soldering, sintering, metal brazing, etc.). As an example, the quartz substrate itself in AQP sensors, is more prone to cracking during high thermal ramps in bonding processes compared to other materials, such as silicon substrates.

Thus, to address these shortcomings, a new sensor and sensing elements are disclosed herein that utilize silicon (Si) to create or form a high vacuum, high Q, hermetically packaged resonator sensing element and sensors made with same that can withstand high temperatures (both in operation and during the initial manufacturing processes) which further allows the sensors to be connected using more advantageous assembly processes (e.g., high temperature/high pressure metal attachment processes such as soldering, sintering, and metal brazing). For example, by making the torque sensor mainly out of silicon (Si) instead of quartz and without the use of polymers, the torque sensor can be brazed directly to the metal surface the torque sensor is being used to monitor (meaning the sensor can withstand very high temperature exposure at least for shorter periods of time like assembly, such as up to 1 100°C). Not only does this formation enable the torque sensor to withstand the high temperatures and pressures associated with that form of attachment process, but forming the torque sensor primarily of Si also enables the torque sensor and associated sensing elements making-up same can withstand far greater temperatures during sensor operation (e.g., operating regularly up to 300°C (such as can happen in rocket and certain jet engine applications) or even up to 600°C without packaging (or just chip on board), if needed. This allows for die attach materials that exhibit significantly lower creep rates, and the resulting sensor will have low drift throughout a greater spectrum of use.

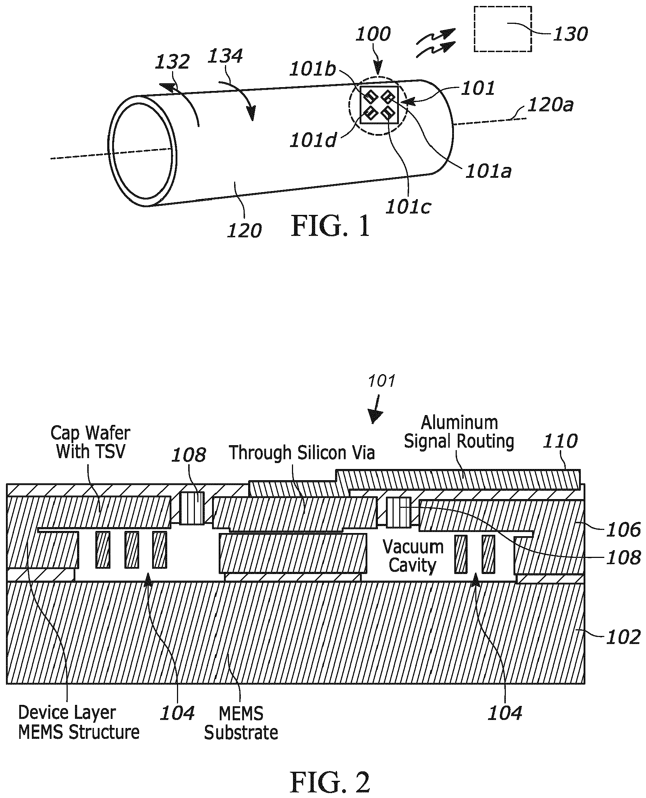

A schematic view of an exemplary torque sensor 100 made of such sensing elements 101 is illustrated in FIGS. 1 and 2. In the application illustrated in FIG. 1, the sensor 100 includes at least one acoustic sensing device 101 configured upon or out of a silicon substrate 102 and is capable of detecting torque associated with an object, such as rotating shaft 120. In one form, the sensor 100 includes circuitry to communicate the data received to a control device or controller 130. While the circuitry could be a hardwired connection between the sensor 100 and controller 130, in the form shown in the example of FIG. 1, the circuitry is a wireless communication configuration. At high temperature applications, however, a hardwired connection will preferably be used. The controller 130 is shown in broken lines as it is optional and could take many forms, and sensor 100 is encircled with a broken line to indicate its placement is also optional and could be located in many locations.

In FIG. 2, a sideview or cross section of an acoustic sensing element or device 101 of the sensor 100 is illustrated. To get here, the process beings with a silicon on insulator wafer bottom 102 that has microelectromechanical systems (MEMs) 104 formed thereon. A cap of silicon on insulator wafer 106 is also formed with through silicon via (TSV) conductors 108. The cap 106 is then flipped over and placed on top of the wafer bottom 102, and the upper material is removed to expose the TSVs 108, which now connect to the MEMs 104. The final conductor layer of metal 110 is added to form the metalized terminals of the sensing element 101.

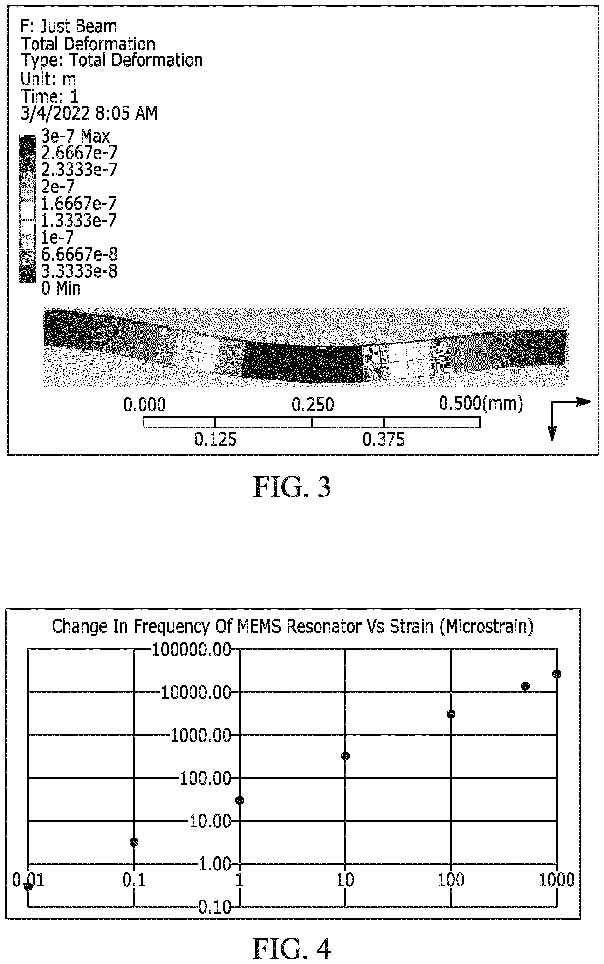

A model of a sensor 100 using one or more silicon resonators 101 as contemplated herein is illustrated in FIG. 3 and shows how input strain will modulate natural frequency over many orders of magnitude and permit measuring 0.01 to 1000 micro-strain. In part this is due to the exceptionally high fracture strain for silicon. Thus, the possibility for large dynamic range for this resonator is significant. For example, in some applications, conventional AQP resonator technology is too sensitive, and the system designer must partly decouple the sensing element by machining a boss onto the shaft at the attachment point. With the silicon resonator solution disclosed herein, the large fracture strain allows designs at a much lower level of sensitivity which results in a more stable sensor. This is further illustrated in the chart of FIG. 4 (a chart of change in frequency of the silicon resonator vs. strain), which shows the silicon resonator output is linear over many orders of magnitude.

The reduced brittleness of silicon, along with its yield strength of seven Gigapascal (7GPa), make it more tolerant to harsh environmental conditions and thus make it capable of withstanding high temperature and/or high-pressure manufacturing processes such as soldering, sintering, brazing, etc.). For example, in one form the sensor 100 may be fastened to the rotating shaft 120 via reactive nano solder (RNT) which allows for a fast and durable connection, but subjects the sensor 100 to high pressure. If this approach were tried with a quartz SAW element, fastening the sensor 100 to the rotating shaft 120 would result in failure when exposed to the high thermal rates/temperatures and pressures used during such processes (e.g., the quartz would be too brittle and crack and the polymer holding the quartz together and the resonator to the object to which it is being connected would melt and/or get damaged). For comparison, the silicon packaged sensor 100 can be molded in a die that operates in excess of 500°C and does not rely on the piezo effect that an AQP SAW works on. A conventional AQP SAW sensor is limited to an operating temperature of 160 °C due to the polymers used therein and (even if you removed the polymers) the piezo effect would degrade as temperature increases (essentially vanishing at 200°C). In some applications, it will not be possible to heat the entire shaft to which sensor 100 is connected to a braze temperature, due to annealing or surface treatment degradation of the shaft. However, in such instances, other processes can be used which still would be too harsh for AQP resonators.

Another benefit of the configuration of sensor 100 is that the silicon has a four percent (4%) fracture strain and can, thus, operate with a wider dynamic range than is possible for conventional AQP sensors. Having a wider range such as this will make the silicon rectifiers usable for a larger array of offerings/applications.

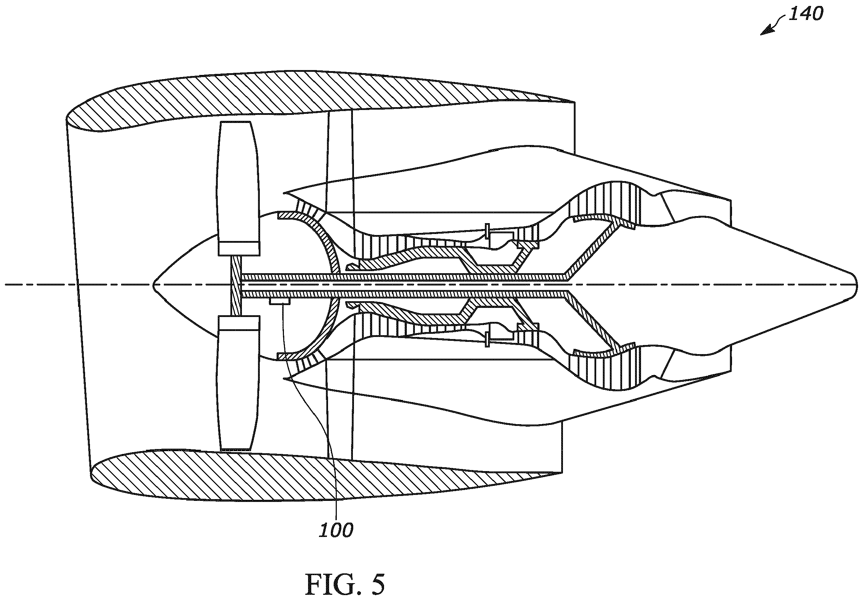

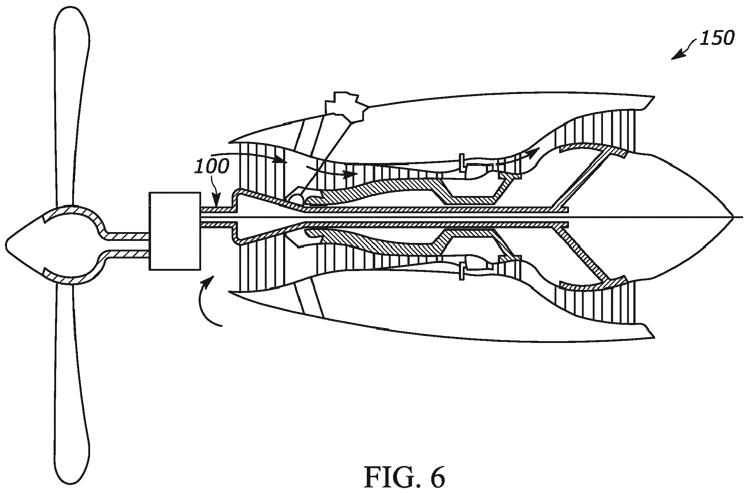

FIGs. 5, 6 and 7 illustrate representative applications for sensor 100 in a jet engine 140, gas turbine engine 150 and wind turbine 160, respectively. However, it should be understood that the sensor elements disclosed herein may be used in a variety of additional ways to form different sensors and components as needed. For example, the sensor elements disclosed herein may form a SAW, a BAW, a surface acoustic wave filter, a surface acoustic wave resonator, a surface acoustic wave delay line, a bulk acoustic wave resonator or a combination thereof depending on desired design configurations.

Further aspects of the present disclosure are provided by the subject matter of the following clauses:

In some forms, a sensing element with improved temperature and pressure characteristics is disclosed having at least one acoustic sensing device formed from a silicon substrate and having a microelectromechanical system without the use of quartz or polymer, wherein the at least one acoustic sensing device detects a torque associated with a metal object subject to said torque, and a high temperature bonding surface for directly connecting the sensing element to the metal object via a high temperature connecting processes comprising at least one of soldering, metalizing and/or brazing.

In some forms, the high temperature connecting process of any preceding clause may include at least one of soldering, metalizing and/or brazing without the use of a polymer adhesive or the need for a polymer adhesive.

In some forms, the at least one acoustic sensing device of any preceding clause comprises a silicon resonator.

In other forms, the at least one acoustic sensing device of any preceding clause comprises a silicon carbide resonator.

In further forms, the at least one acoustic sensing device of any preceding clause comprises a silicon surface acoustic wave (SAW) resonator or a silicon bulk acoustic wave (BAW) resonator.

For example, the at least one acoustic sensing device of any preceding clause may be a silicon bulk acoustic wave (BAW) resonator with a first silicon resonator orientated ninety degrees (90°) to a second silicon resonator, with the first silicon resonator experiencing compressive stress and the second silicon resonator experiencing tensile stress when the metal object is rotated in a first direction (e.g., arrow 132, FIG. 1). In some forms, the first silicon resonator experiencing tensile stress and the second silicon resonator experiencing compressive stress when the metal object is rotated in a second direction (e.g., arrow 134, FIG. 1) opposition the first direction (e.g., transverse the direction of travel of arrow).

In some forms, the first silicon resonator of any preceding clause and second silicon resonator of any preceding clause are each orientated forty-five degrees (45°) with respect to a longitudinal axis of the metal object.

The sensing element of any preceding clause may include a third silicon resonator and a fourth silicon resonator orientated ninety degrees (90°) to one another and forty-five degrees (45°) to the longitudinal axis of the metal object, together the first silicon resonator, second silicon resonator, third silicon resonator and fourth silicon resonator collectively forming a single torque sensor or single torque sensor assembly.

In one form, the single torque sensor assembly of any preceding clause is bonded to the metal object via the high temperature bonding surface (e.g., located underneath or on the bottom of sensor assembly) via the high temperature connecting processes comprising at least one of soldering, metalizing and/or brazing, without the need for a polymer adhesive. The single torque sensor of any preceding clause may be configured to withstand continual operation without degradation at temperatures up to three hundred degrees Celsius (300°C). In other forms the single torque sensor of any preceding clause may be configured to withstand continual operation without degradation at temperatures up to three hundred degrees Celsius (600°C).

As mentioned above, the concepts disclosed herein relate to sensing elements and may be used in different types of sensors. In addition to the above embodiments, apparatus and systems, it should be appreciated that various related methods have also been disclosed herein. For example, a method for forming a sensing element in accordance with any preceding clause is disclosed comprising: providing a silicon on insulator wafer bottom, a silicon on insulator wafer cap, microelectromechanical systems, through silicon vias (TSVs) and metal; forming microelectromechanical systems on the silicon on insulator wafer bottom; forming through silicon vias (TSVs) on the silicon on insulator wafer cap and bonding the silicon on insulator wafer cap to the silicon on insulator wafer bottom; removing silicon from the silicon on insulator wafer cap to expose the through silicon vias (TSVs); and adding metal to the through silicon vias (TSVs) to form terminals thereby creating a completed sensing element.

In some forms, the method for forming a sensing element in accordance with any preceding clause may include providing a first sensing element and a second sensing element and arranging the first sensing element on a base and the second sensing element on the base at a first ninety degree (90°) angle to the first sensing element.

The method for forming a sensing element in accordance with any preceding clause may include providing a third sensing element and a fourth sensing element, and arranging the third sensing element on the base and the fourth sensing element on the base at a second ninety degree (90°) angle to the third sensing element.

The method for forming a sensing element in accordance with any preceding clause may include arranging the third sensing element on the base at a third ninety degree (90°) angle to the first sensing element, and arranging the fourth sensing element on the base at a fourth ninety degree (90°) angle to the second sensing element.

The method for forming a sensing element in accordance with any preceding clause may include arranging a plurality of the sensing elements discussed above to form a torque sensor.

Beyond the methods discussed above, it should also be understood that various forms of sensors are contemplated herein. For example, in some forms, a harsh environment torque sensor is disclosed comprising: a first acoustic sensing resonator formed from a silicon substrate and having a first microelectromechanical system; a second acoustic sensing resonator formed from the silicon substrate and having a second microelectromechanical system, the second acoustic sensing resonator being arranged on the silicon substrate at a ninety degree (90°) angle with respect to the first acoustic sensing resonator so that one of the first acoustic sensing resonator and second acoustic sensing resonator senses compressive forces and the other of the first acoustic sensing resonator and second acoustic sensing resonator senses tensile strain and together the first acoustic sensing resonator and second acoustic sensing resonator form a torque sensor; and a high temperature bonding surface connected to the torque sensor for directly connecting the torque sensor to a metal object via a high temperature connecting processes comprising at least one of soldering, metalizing and/or brazing to form a harsh environment torque sensor that can withstand prolonged exposure to temperatures of up to three hundred degree Celsius (300°C).

In some forms, a harsh environment torque sensor in accordance with any preceding clause has a high temperature bonding surface and high temperature connecting process all the harsh environment torque sensor to withstand prolonged exposure to temperatures of up to six hundred degree Celsius (600°C).

In other forms, a harsh environment torque sensor in accordance with any preceding clause may further include a third acoustic sensing resonator formed from the silicon substrate and having a third microelectromechanical system; and a fourth acoustic sensing resonator formed from the silicon substrate and having a fourth microelectromechanical system, the fourth acoustic sensing resonator being arranged on the silicon substrate at a ninety degree (90°) angle with respect to the third acoustic sensing resonator so that one of the third acoustic sensing resonator and fourth acoustic sensing resonator senses compressive forces and the other of the third acoustic sensing resonator and fourth acoustic sensing resonator senses tensile strain and together the first acoustic sensing resonator, the second acoustic sensing resonator, the third acoustic sensing resonator and the fourth acoustic sensing resonator form the harsh environment torque sensor.

In some forms, a harsh environment torque sensor in accordance with any preceding clause the first acoustic sensing resonator is arranged on the silicon substrate at a ninety degree (90°) angle with respect to the third acoustic sensing resonator, and the second acoustic sensing resonator is arranged on the silicon substrate at a ninety degree (90°) angle to the fourth acoustic sensing resonator.

In yet other forms, a harsh environment torque sensor in accordance with any preceding clause the first acoustic sensing resonator, second acoustic sensing resonator, third acoustic sensing resonator and fourth acoustic sensing resonator are at least one of silicon acoustic wave (SAW) resonators, bulk silicon acoustic wave (BAW) resonators and/or silicon carbide (SiC) resonators.

A harsh environmental torque sensor in accordance with any preceding clause may include a bifurcation line may be drawn across the harsh environment torque sensor separating the harsh environment torque sensor into a first portion having the first acoustic sensing resonator and the second acoustic sensing resonator and a second portion having the third acoustic sensing resonator and the fourth acoustic sensing resonator, and the first acoustic sensing resonator and the second acoustic sensing resonator are positioned on the first portion such that they are at a forty-five degree (45°) angle with respect to the bifurcation line and the third acoustic sensing resonator and the fourth acoustic sensing resonator are positioned on the second portion such that they are at a forty-five degree (45°) angle with respect to the bifurcation line.

Thus, as stated above, various sensing elements and sensors are disclosed herein that are capable of addressing the harsh environment constraints that apply to convention sensing elements and sensors (e.g., temperature limitations, strength of bonding limitations, material limitations such as rigidity or brittleness, drift limitations, etc.). For example in some forms sensing elements are provided that are formed directly on silicon substrates with high temperature bonding surfaces and the lack of use of materials that otherwise limit the temperature to which the component may be subjected (e.g., such as use of polymers that melt at high temperature or materials that become too brittle if exposed to high temperatures, etc.). In some forms silicon based acoustic resonators are utilized that are formed directly on a silicon substrate along with microelectromechanical systems (MEMs) and having high temperature bonding surfaces such that the substrate may be connected directly to a structure to be monitored via high temperature bonding processes (e.g., soldering, metalizing and/or brazing). The silicon acoustic resonators may be made from surface acoustic wave (SAW) resonators, bulk surface acoustic wave (BAW) resonators and/or silicon carbide (SiC) resonators.

Those skilled in the art will recognize that a wide variety of modifications, alterations, and combinations can be made with respect to the above-described embodiments without departing from the scope of the disclosure, and that such modifications, alterations, and combinations are to be viewed as being within the ambit of the disclosure concept.

## Claims

1. A sensing element with improved temperature and pressure characteristics comprising:
at least one acoustic sensing device (101) formed from a silicon substrate (102) and having a microelectromechanical system (104) without the use of quartz or polymer, wherein the at least one acoustic sensing device (101) detects a torque associated with a metal object (120) subject to said torque; and
a high temperature bonding surface for directly connecting the sensing element to the metal object (120) via a high temperature connecting processes comprising at least one of soldering, metalizing and/or brazing.

2. The sensing element of claim 1 wherein the at least one acoustic sensing device (101) comprises a silicon surface acoustic wave (SAW) resonator or a silicon bulk acoustic wave (BAW) resonator.

3. The sensing element of claim 2 wherein the at least one acoustic sensing device (101) is a silicon bulk acoustic wave (BAW) resonator with a first silicon resonator (101a) orientated ninety degrees (90°) to a second silicon resonator (101b),
with the first silicon resonator (101a) experiencing compressive stress and the second silicon resonator (101b) experiencing tensile stress when the metal object is rotated in a first direction (132).

4. The sensing element of claim 3 wherein the first silicon resonator (101a) and second silicon resonator (101b) are each orientated forty-five degrees (45°) with respect to a longitudinal axis (120a) of the metal object (120).

5. The sensing element of claim 4 further having a third silicon resonator (101c) and a fourth silicon resonator (101d) orientated ninety degrees (90°) to one another and forty-five degrees (45°) to the longitudinal axis (120a) of the metal object (120), together the first silicon resonator (101a), second silicon resonator (101b), third silicon resonator (101c) and fourth silicon resonator (101d) collectively forming a single torque sensor assembly (100).

6. The sensing element of claim 5 wherein the single torque sensor assembly (100) is bonded to the metal object (120) via the high temperature bonding surface via the high temperature connecting processes comprising at least one of soldering, metalizing and/or brazing, without the use of a polymer adhesive.

7. A method for forming a sensing element (101) comprising:
providing a silicon on insulator wafer bottom (102), a silicon on insulator wafer cap (106), microelectromechanical systems (104), through silicon vias (TSVs) (108) and metal (110);
forming microelectromechanical systems (104) on the silicon on insulator wafer bottom (102);
forming through silicon vias (TSVs) (108) on the silicon on insulator wafer cap (106) and bonding the silicon on insulator wafer cap (106) to the silicon on insulator wafer bottom (102);
removing silicon from the silicon on insulator wafer cap (106) to expose the through silicon vias (TSVs) (108); and
adding metal (110) to the through silicon vias (TSVs) (108) to form terminals to create a completed sensing element.

8. The method of claim 7 comprising:
providing a first sensing element in accordance with claim 11 (101a) and a second sensing element in accordance with claim 11 (101b); and
arranging the first sensing element (101a) on a base (102) and the second sensing element (101b) on the base (102) at a first ninety degree (90°) angle to the first sensing element (101a) to form a torque sensor (100).

9. The method of claim 8 further comprising:
providing a third sensing element in accordance with claim 11 (101c) and a fourth sensing element in accordance with claim 11 (101d); and
arranging the third sensing element (101c) on the base (102) and the fourth sensing element (101d) on the base (102) at a second ninety degree (90°) angle to the third sensing element (101c).

10. The method of claim 9 further comprising:
arranging the third sensing element (101c) on the base (102) at a third ninety degree (90°) angle to the first sensing element (101a); and
arranging the fourth sensing element (101d) on the base (102) at a fourth ninety degree (90°) angle to the second sensing element (101b).

11. A harsh environment torque sensor (100) comprising:
a first acoustic sensing resonator (101a) formed from a silicon substrate (102) and having a first microelectromechanical system;
a second acoustic sensing resonator (101b) formed from the silicon substrate (102) and having a second microelectromechanical system, the second acoustic sensing resonator (101b) being arranged on the silicon substrate (102) at a ninety degree (90°) angle with respect to the first acoustic sensing resonator (101a) so that one of the first acoustic sensing resonator (101a) and second acoustic sensing resonator (101b) senses compressive forces and the other of the first acoustic sensing resonator (101a) and second acoustic sensing resonator (101b) senses tensile strain and together the first acoustic sensing resonator (101a) and second acoustic sensing resonator (101b) form a torque sensor (100); and
a high temperature bonding surface connected to the torque sensor (100) for directly connecting the torque sensor (100) to a metal object (120) via a high temperature connecting processes comprising at least one of soldering, metalizing and/or brazing to form a harsh environment torque sensor that can withstand prolonged exposure to temperatures of up to three hundred degree Celsius (300°C).

12. The harsh environment torque sensor (100) of claim 11 further including:
a third acoustic sensing resonator (101c) formed from the silicon substrate (102) and having a third microelectromechanical system; and
a fourth acoustic sensing resonator (101d) formed from the silicon substrate (102) and having a fourth microelectromechanical system, the fourth acoustic sensing resonator being arranged on the silicon substrate (102) at a ninety degree (90°) angle with respect to the third acoustic sensing resonator (101c) so that one of the third acoustic sensing resonator (101c) and fourth acoustic sensing resonator (101d) senses compressive forces and the other of the third acoustic sensing resonator (101c) and fourth acoustic sensing resonator (101d) senses tensile strain and together the first acoustic sensing resonator (101a), the second acoustic sensing resonator (101b), the third acoustic sensing resonator (101c) and the fourth acoustic sensing resonator (101d) form the harsh environment torque sensor (100).

13. The harsh environment torque sensor (100) of claim 12 wherein the first acoustic sensing resonator (101a) is arranged on the silicon substrate (102) at a ninety degree (90°) angle with respect to the third acoustic sensing resonator (101c), and the second acoustic sensing resonator (101b) is arranged on the silicon substrate (102) at a ninety degree (90°) angle to the fourth acoustic sensing resonator (101d).

14. The harsh environment torque sensor (100) of claim 13 wherein the first acoustic sensing resonator (101a), second acoustic sensing resonator (101b), third acoustic sensing resonator (101c) and fourth acoustic sensing resonator (101d) are at least one of silicon acoustic wave (SAW) resonators, bulk silicon acoustic wave (BAW) resonators and/or silicon carbide (SiC) resonators.

15. The harsh environment torque sensor of claim 13 or 14 wherein a bifurcation line may be drawn across the harsh environment torque sensor (100) separating the harsh environment torque sensor (100) into a first portion having the first acoustic sensing resonator (101a) and the second acoustic sensing resonator (101b) and a second portion having the third acoustic sensing resonator (101c) and the fourth acoustic sensing resonator (101d), and the first acoustic sensing resonator (101a) and the second acoustic sensing resonator (101b) are positioned on the first portion such that they are at a forty-five degree (45°) angle with respect to the bifurcation line and the third acoustic sensing resonator (101c) and the fourth acoustic sensing resonator (101d) are positioned on the second portion such that they are at a forty-five degree (45°) angle with respect to the bifurcation line.
